(19) Europäisches Patentamt
European Patent Office
Office européen des brevets

(11) Publication number: **0 285 074 B1**

(12) # EUROPEAN PATENT SPECIFICATION

(45) Date of publication of patent specification: **13.05.92** (51) Int. Cl.$^5$: **H01L 23/48**

(21) Application number: **88105000.9**

(22) Date of filing: **28.03.88**

(54) **Pressure-contact type semiconductor device.**

(30) Priority: **31.03.87 JP 78653/87**

(43) Date of publication of application:
**05.10.88 Bulletin 88/40**

(45) Publication of the grant of the patent:
**13.05.92 Bulletin 92/20**

(84) Designated Contracting States:
**DE FR GB**

(56) References cited:
**DE-A- 3 346 833**
**GB-A- 2 168 529**
**US-A- 4 402 004**

(73) Proprietor: **KABUSHIKI KAISHA TOSHIBA**
**72, Horikawa-cho Saiwai-ku**
**Kawasaki-shi Kanagawa-ken 210(JP)**

(72) Inventor: **Matsuda, Hideo c/o Patent Division**
**Kabushiki Kaisha Toshiba 1-1 Shibaura**
**1-chome**
**Minato-ku Tokyo 105(JP)**
Inventor: **Usui, Yasunori c/o Patent Division**
**Kabushiki Kaisha Toshiba 1-1 Shibaura**
**1-chome**
**Minato-ku Tokyo 105(JP)**
Inventor: **Kojima, Shinjiro c/o Patent Division**
**Kabushiki Kaisha Toshiba 1-1 Shibaura**
**1-chome**
**Minato-ku Tokyo 105(JP)**
Inventor: **Ando, Masaru c/o Patent Division**
**Kabushiki Kaisha Toshiba 1-1 Shibaura**
**1-chome**
**Minato-ku Tokyo 105(JP)**

(74) Representative: **Henkel, Feiler, Hänzel & Partner**
**Möhlstrasse 37**
**W-8000 München 80(DE)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid (Art. 99(1) European patent convention).

EP 0 285 074 B1

## Description

This invention relates to a pressure contact type semiconductor device which is used with semiconductor elements sandwiched between electrodes to which external force is applied, and more particularly, to a semiconductor device such as a mesa transistor, a gate turn-off thyristor, and a high-speed thyristor in which main and control electrodes are interlaced with each other.

Because it possesses a high electrical conductivity, aluminum is generally used to form wirings and electrodes of semiconductor devices. However, since aluminum is a soft metal, it is not always best suited for high-power pressure contact type semiconductor devices. This is because the semiconductor element of this type of semiconductor device is pressed with a higher pressure, since such a semiconductor device is formed to have a higher power. The term "pressure contact" used in this specification means that two things can be contacted together simply by pressing them against each other, using a high pressure. Assume that the semiconductor element is a power transistor having a diameter of 40 mm. In this case, the emitter and base electrodes of the transistor are formed of aluminum layers of a thickness of, for example, 10 $\mu$m. The emitter and base electrodes are alternately arranged at intervals of approx. 200 to 300 $\mu$m, with each of the emitter electrodes being formed at a position higher by 20 $\mu$m with respect to that of each of the base electrodes. The power transistor is sandwiched between external electrodes of copper and in pressure contact with the external electrodes under a pressure of 1.0 to 1.5 tons. A heat buffer plate is placed between the emitter and each of the base electrodes of the power transistor and the external electrodes, as known from DE-A-3 346 833.

Even if the heat buffer plate of the above-described power semiconductor device is inserted between the emitter electrode and the external electrode, the emitter electrode will undergo thermal fatigue after it has been subjected to heat cycle due to repetitive switching operations, for example. Since thermal fatigue may cause the emitter electrode to be put out transversely, with the possibility that it will come into contact with the base electrode, the emitter and base electrodes are set in contact with each other, making part of the semiconductor device defective. As thermal fatigue increases, the heat buffer plate is in pressure contact with the semiconductor substrate on which the semiconductor element is formed by means of the emitter electrode. If, in this condition, the heat buffer plate is subjected to thermal expansion, this may cause the semiconductor substrate to crack due to stretching.

Cracking of the semiconductor substrate, as well as short circuiting between the emitter and base electrodes, can be prevented by using metal which is as soft as aluminum to form the heat buffer plate. However, when the heat buffer plate is formed of soft metal, there is a possibility that the external electrodes may be deformed when the semiconductor element is in pressure contact, making it impossible to apply a uniform pressure to the semiconductor element. Thus, it becomes difficult to control the pressure applied to the semiconductor element by means of the external electrodes.

As has been described above, thermal fatigue of the electrode of the prior art pressure contact type semiconductor device occurs when the electrode is subjected to heat cycle caused by repetitive switching operations, which causes short-circuiting of the emitter and the base electrodes and cracks in the semiconductor substrate.

An object of this invention is to provide a pressure contact type semiconductor device in which defect due to the thermal fatigue of electrodes of semiconductor elements to be pressure contacted can be effectively prevented.

To solve this object the present invention provides a pressure contact type semiconductor device as specified in claim 1.

With this construction, since the soft and hard metal plates are disposed between the soft metal electrode of the semiconductor device and the external electrode, the pressure applied to the electrode of the semiconductor device can be shared by the soft metal plate. Therefore, deformation of the output electrode of the semiconductor element can be made small. Further, use of the hard metal plate can prevent deformation of the external electrode which will be caused at the time of pressure contacting the semiconductor element by use of the soft metal plate. Thus, a pressure contact type semiconductor device can be obtained in which the thermal fatigue of the electrode of the semiconductor element can be suppressed and defect due to the thermal fatigue can be prevented.

This invention can be more fully understood from the following detailed description when taken in conjunction with the accompanying drawings, in which:

Fig. 1 is a cross sectional view of a pressure contact type semiconductor device according to an embodiment of this invention;

Fig. 2 is a cross sectional view of an enlarged portion mainly showing the emitter electrode of an NPN transistor element in the device of Fig. 1;

Fig. 3 is a cross sectional view for illustration of a problem which may occur when the device of the structure shown in Fig. 1 is used;

Fig. 4 is a cross sectional view of a device of an example obtained by modifying the device of Fig. 1 so as to solve the problem indicated in Fig. 3;

Fig. 5 is a cross sectional view of an enlarged portion mainly showing the emitter electrode of an NPN transistor element in the device of Fig. 4;

Fig. 6 is a cross sectional view of a device of another example obtained by modifying the device of Fig. 1 so as to solve the problem indicated in Fig. 3;

Fig. 7 is a cross sectional-view for illustration of another problem which may occur when the device of the structure shown in Fig. 1 is used; and

Fig. 8 is a cross sectional view of a device of an example obtained by modifying the device of Fig. 1 so as to solve the problem indicated in Fig. 7.

Fig. 1 is a cross sectional view of a pressure contact type semiconductor device according to an embodiment of this invention. In the embodiment of Fig. 1, a flat type power transistor is provided as an example of the pressure contact type semiconductor device. In a ceramic casing 1, a NPN transistor element 2 is provided. The element 2 has a base region 4 of a P-type impurity region formed on a N-type silicon substrate 3 acting as a collector region. Emitter regions 5-1 to 5-4 of N-type impurity regions are formed on the base region 4. The emitter regions 5-1 to 5-4 are formed with mesa structure. Emitter electrodes 6-1 to 6-4 are formed on the emitter regions 5-1 to 5-4. Base electrodes 7-1 to 7-5 are formed on the base region 4. Base electrodes 7-1 to 7-5 and the emitter electrodes 6-1 to 6-4 are alternately arranged. The emitter electrodes 6-1 to 6-4 and the base electrodes 7-1 to 7-5 are formed of soft metal such as aluminum, for example. The transistor element 2 is in pressure contact with external electrodes 8 and 9 of copper by pressure applied in a direction shown by arrows P1 and P2 in Fig. 1. The emitter electrodes 6-1 to 6-4 of the element 2 are pressed against a soft metal plate 10 formed of silver (Ag), aluminum (Aℓ) or copper (Cu) via a heat buffer plate 11 formed of a hard metal such as molybdenum (Mo) or tungsten (W) by means of the external electrode 8. It is desirable that the soft metal plate 10 be made of a metal having a Vickers hardness which ranges from 0.3 times to 1.5 times the Vickers hardness of the material of the emitter electrodes 6-1 and 6-2. Hence, the plate 10 can be made of a metal harder than the metal forming the emitter electrodes 6-1 to 6-4. Silver has a Vickers hardness of 27.29; copper has a Vickers hardness of 43.96; aluminum has a Vickers hardness of 82.01 (the aluminum formed on the silicon substrate has a Vickers hardness of about 60); molybdenum has a Vickers hardness of 279.2; and tungsten has a Vickers hardness of 446.6. Therefore, as has been described when the emitter electrodes 6-1 to 6-4 are made of aluminum, the plate 10 can be made of silver, copper, or aluminum, and cannot be made of molybudenum or tungsten. When the electrodes 6-1 to 6-4 are made of aluminum vapor-deposited on the silicon substrate, it is desirable that the plate 10 be made of a metal whose Vickers hardness is about half or less the Vickers hardness of this aluminum. The substrate 3 of the transistor element 2 is connected to the external electrode 9 via a fusible metal layer 12 such as solder and a heat buffer plate 13. The heat buffer plate 13 is formed of the same material as the heat buffer plate 11. A lead wire 14 is connected to the base electrode 7-1 of the transistor element 2 and formed to extend externally from the casing 1. The base electrodes 7-1 to 7-5 appear to be formed separately from each other in the cross sectional view of Fig. 1, but they are actually connected to each other on substantially the same plane.

The thickness of the emitter electrodes 6-1 to 6-4 and the base electrodes 7-1 to 7-5 is set to 10 to 15 $\mu$m, the thickness of the soft metal plate 10 is set to 50 to 200 $\mu$m, and the thickness of the heat buffer plate 11 is set to 400 $\mu$m to 1 mm.

With this construction, since the soft metal plate 10 having substantially an equal hardness as the emitter electrodes 6-1 to 6-4 is placed between the hard heat buffer plate 11 and the soft emitter electrodes 6-1 to 6-4, a pressure to be applied to the emitter electrodes 6-1 to 6-4 when the transistor element 2 is in pressure contact by means of external electrode 9 can be shared with the soft metal plate 10 as clearly shown in Fig. 2. That is, the soft metal plate 10 is deformed at the time of pressure contacting of transistor element 2, and it absorbs part of pressure to be applied to the emitter electrodes 6-1 to 6-4, causing the emitter electrodes 6-1 to 6-4 to be less deformed. Further, the presence of the soft metal plate 10 causes the emitter electrodes 6-1 to 6-4 to be deformed so as to have a round upper surface at the time of pressure contacting, and the emitter electrodes 6-1 to 6-4 will not be put out transversely. In addition, since the heat buffer plate 11 formed of hard metal is placed between the soft metal plate 10 and the external electrode 8, deformation of the external electrode 8 caused at the time of pressure contacting due to the use of the soft metal plate 10 can be prevented. Thus, it is possible to prevent a short circuit between the emitter electrodes 6-1 to 6-4 and the base electrodes 7-1 to 7-5 and formation of crack in substrate 3, and makes it unnecessary to effect troublesome pressure control caused by deformation of the external electrode 8.

In the transistor element 2 as described above, when part of the element 2 is defective, an emitter electrode corresponding to the defective portion is removed. However, if the emitter electrode 6-2 corresponding to the defective portion is removed as shown in Fig. 3, the distance of the emitter electrode 6-1 from the adjacent emitter electrode, in this example, emitter electrode 6-3 becomes large, and the soft metal plate 10 may be largely curved. In the case where the soft metal plate 10 is largely curved, the soft metal plate 10 may be brought into contact with the emitter region 5-2 corresponding to the removed emitter electrode. When such a defect occurs, the defective portion will affect the operation of the transistor element 2, thus causing the pressure contact type semiconductor device itself to be defective.

In order to prevent the aforementioned defect, the heat buffer plate 15 formed of a hard metal such as molybdenum (Mo) or tungsten (W), the soft metal plate 10 formed of aluminum (Aℓ), silver (Ag), copper (Cu) or the like and the hard metal plate 11 formed of molybdenum (Mo), tungsten (W) or the like are arranged between the emitter electrodes 6-1 to 6-4 and the external electrode 8 as shown in Fig. 4. In this case, the thickness of the heat buffer plate 15 is set to 50 $\mu$m, the thickness of the soft metal plate 10 is set to 100 $\mu$m and thickness of the hard metal plate 11 is set to 400 $\mu$m.

With this construction, since the soft metal plate 10 is sandwiched between the hard metal plates 11 and 15, the degree of curve of the soft metal plate 10 can be suppressed by the hard heat buffer plate 15. Therefore, even if the distance between adjacent electrodes becomes large by elimination of the emitter electrode 6-2 at the defective portion, the soft metal plate (heat buffer plate in the case of Fig. 5) will not be brought into contact with the emitter region 5-2. In this case, the hard heat buffer plate 15 is set in contact with the emitter electrodes 6-1, 6-3, ... However, the heat buffer metal plate 15 is formed thin as described before so as to be slightly deformed together with the soft metal plate 10 at the time of pressure contacting. Therefore, even if the emitter electrode is put out transversely when the pressure is applied to external electrodes 8 and 9, the emitter electrodes 6-1, 6-3, ... will not be short-circuited with the base electrodes 7-1 to 7-5.

Fig. 6 shows another example of the structure for preventing the defect shown in Fig. 3. In Fig. 6, an insulation material 16 is formed on the emitter region 5-2 having the emitter electrode 6-2 removed. Polyimide is used as the insulation material 16, for example. After polyimide is coated on the emitter region 5-2, heat treatment is effected to cure the same. When cured by the heat treatment, polyimide shrinks. Even when polyimide is coated higher than the emitter electrodes 6-1, 6-3, ..., it becomes lower when it is subjected to heat treatment. Thus, even if the soft metal plate 10 is largely curved when the emitter electrodes 6-1, 6-3, ... are pressure contacted, no problem will occur.

With the construction described above, defects due to the contact of the curved soft metal plate with the defective segment (emitter region 5-2) can be prevented.

In the semiconductor device, hillock may occur in the electrode of the semiconductor element, and defects called pin holes may occur in the insulation film formed on the semiconductor element Fig. 7 indicates the case where a hillock 17 occurs in the base electrode 7-2, and a pin hole 19 occurs in an insulation film 18 formed for surface protection of the transistor element. When the hillock occurs as shown in Fig. 7, the hillock 17 will be brought into contact with the soft metal plate 10 to cause a short circuit between the emitter electrodes 6-1, 6-2, ... and the base electrodes 7-2. Further, if the pin hole 19 occurs, the soft metal plate 10 will become in contact with the base electrode 7-2 via the pin hole 19, causing a short circuit between the emitter electrodes 6-1, 6-2, ... and the base electrode 7-2.

In order to prevent such defects as described above, the thickness H1 of the emitter electrodes 6-1, 6-2, ... is set larger than the thickness H2 of the base electrode 7-2 as shown in Fig. 8.

With this construction, even if hillock 17 occurs in the base electrode 7-2 or pin hole 19 is formed in the insulation film 18 formed for surface protection of the transistor element, it will be difficult for the curved portion of the soft metal plate 10 to reach the hillock 17 and the pin hole 19. Thus, contact between the hillock 17 and the soft metal plate 10 and contact of the soft metal plate 10 with the base electrode 7-2 via the pin hole 19 can be prevented. Further, the construction is effective to prevent contact between the emitter electrode 5-2 and the soft metal plate 10 due to the curved soft metal plate 10 shown in Fig. 3.

In the embodiments described above, a case where the semiconductor device is a flat type power transistor is explained, but the same effect can be attained when the semiconductor device is formed as a different type of semiconductor element such as gate turn-off thyristor or high-speed thyristor.

As described above, according to this invention, a pressure contact type semiconductor device is provided in which defect due to thermal fatigue of the electrode of the semiconductor element can be prevented.

## Claims

1. A pressure contact type semiconductor device used with pressure (P1, P2) applied to external electrodes (8, 9) and having at least one semiconductor element (2) of mesa structure sandwiched between said external electrodes (8, 9), said device further comprising a composite plate of a soft metal plate (10) and a hard metal plate (11) disposed between one of said external electrodes (8) and output electrodes (6-1 to 6-4) of said semiconductor element (2), said soft metal plate (10) being formed in contact with said output electrodes (6-1 to 6-4) and said hard metal plate (11) being formed in contact with said one external electrode (8) wherein said soft metal plate (10) has a Vickers hardness which ranges from 0.3 times to 1.5 times the Vickers hardness of said output electrodes (6-1 to 6-4) of said semiconductor element (2).

2. A pressure contact type semiconductor device according to claim 1 , characterized in that said composite plate further includes a thin hard metal plate (15), said thin hard metal plate (15) is formed in contact with said output electrodes (6-1 to 6-4), said soft metal plate (10) is formed on said thin hard metal plate (15), and said hard metal plate (11) is formed on said soft metal plate (10).

3. A pressure contact type semiconductor device according to claim 1, characterized in that said soft metal plate (10) has substantially the same hardness as said output electrodes (6-1 to 6-4).

4. A pressure contact type semiconductor device according to claim 1, characterized in that said output electrodes (6-1 to 6-4) of said semiconductor element (2) are formed of aluminum, said soft metal plate (10) is formed of metal selected from the group consisting of aluminum, silver and copper.

5. A pressure contact type semiconductor device according to claim 1, characterized in that said semiconductor element (2) includes further output electrodes (7-1, 7-2) disposed in a position lower than said output electrodes (6-1 to 6-4) so as not to be pressure-contacted by means of said one external electrode (8), and said output electrodes (6-1 to 6-4) are formed thicker than said further output electrodes (7-1 to 7-5).

6. A pressure contact type semiconductor device according to claim 1, characterized in that an insulation material (16) thinner than said output electrodes (6-1 to 6-4) is coated on a semiconductor region (5-2) which is exposed by removing part of said output electrodes (6-1 to 6-4).

7. A pressure contact type semiconductor device according to claim 6, characterized in that said insulation material (16) is heat-shrinkable.

8. A pressure contact type semiconductor device according to claim 7, characterized in that said heat-shrinkable insulation material (16) is polyimide.

## Revendications

1. Dispositif semiconducteur du type à contact par pression utilisé avec une pression (P1, P2) appliquée à des électrodes externes (8, 9) et ayant au moins un élément semiconducteur (2) de structure mésa intercalé entre lesdites électrodes externes (8, 9), ledit dispositif comprenant en outre une plaque composite constituée par une plaque en métal tendre (10) et une plaque en métal dur (11), disposée entre l'une desdites électrodes externes (8) et des électrodes de sortie (6-1 à 6-4) dudit élément semiconducteur (2), ladite plaque en métal tendre (10) étant formée en contact avec lesdites électrodes de sortie (6-1 à 6-4) et ladite plaque en métal dur (11) étant formée en contact avec ladite électrode externe (8), dans lequel ladite plaque en métal tendre (10) a une dureté Vickers comprise entre 0,3 fois et 1,5 fois la dureté Vickers desdites électrodes de sortie (6-1 à 6-4) dudit élément semiconducteur (2).

2. Dispositif semiconducteur du type à contact par pression selon la revendication 1, caractérisé en ce que ladite plaque composite comprend en outre une plaque en métal dur mince (15), en ce que ladite plaque en métal dur mince (15) est formée en contact avec lesdites électrodes de sortie (6-1 à 6-4), en ce que ladite plaque en métal tendre (10) est formée sur ladite plaque en métal dur mince (15) et en ce que ladite plaque en métal dur (11) est formée sur ladite plaque en métal tendre (10).

3. Dispositif semiconducteur du type à contact par pression selon la revendication 1, caractérisé en ce que ladite plaque en métal tendre (10) a sensiblement la même dureté que lesdites électrodes de sortie (6-1 à 6-4).

**4.** Dispositif semiconducteur du type à contact par pression selon la revendication 1, caractérisé en ce que lesdites électrodes de sortie (6-1 à 6-4) dudit élément semiconducteur (2) sont en aluminium, en ce que ladite plaque en métal tendre (10) est en un métal sélectionné dans le groupe constitué par l'aluminium, l'argent et le cuivre.

**5.** Dispositif semiconducteur du type à contact par pression selon la revendication 1, caractérisé en ce que ledit élément semiconducteur (2) comprend des électrodes de sortie additionnelles (7-1, 7-2) disposées en une position plus basse que celle desdites électrodes de sortie (6-1 à 6-4) de façon à ne pas être mises en contact par pression au moyen de ladite électrode externe (8) et en ce que lesdites électrodes de sortie (6-1 à 6-4) sont plus épaisses que lesdites électrodes de sortie additionnelles (7-1 à 7-5).

**6.** Dispositif semiconducteur du type à contact par pression selon la revendication 1, caractérisé en ce qu'un matériau isolant (16) plus mince que lesdites électrodes de sortie (6-1 à 6-4) est appliqué sur une zone du semiconducteur (5-2) exposée par enlèvement d'une partie desdites électrodes de sortie (6-1 à 6-4).

**7.** Dispositif semiconducteur du type à contact par pression selon la revendication 6, caractérisé en ce que ledit matériau isolant (16) est thermorétrécissable.

**8.** Dispositif semiconducteur du type à contact par pression selon la revendication 7, caractérisé en ce que ledit matériau isolant thermorétrécissable (16) est un polyimide.

## Patentansprüche

**1.** Halbleiteranordnung vom Druckkontakt-Typ, die bei auf externe Elektroden (8, 9) einwirkendem Druck (P1, P2) verwendet wird und wenigstens ein Halbleiterelement (2) von Mesastruktur hat, das zwischen die externen Elektroden (8, 9) geschichtet ist, wobei die Anordnung außerdem eine zusammengesetzte Platte einer Weichmetallplatte (10) und einer Hartmetallplatte (11) aufweist, die zwischen einer der externen Elektroden (8) und Ausgangselektroden (6-1 bis 6-4) des Halbleiterelementes (2) gelegen ist, die Weichmetallplatte (10) in Kontakt mit dem Ausgangselektroden (6-1 bis 6-4) und die Hartmetallplatte (11) in Kontakt mit der einen externen Elektrode (8) gebildet ist, und wobei die Weichmetallplatte (10) eine Vickers-Härte hat, die zwischen dem 0,3-fachen bis 1,5-fachen der Vickers-Härte der Ausgangselektroden (6-1 bis 6-4) des Halbleiterelementes (2) liegt.

**2.** Halbleiteranordnung vom Druckkontakt-Typ nach Anspruch 1, dadurch gekennzeichnet, daß die zusammengesetzte Platte außerdem eine dünne Hartmetallplatte (15) hat, die in Kontakt mit den Ausgangselektroden (6-1 bis 6-4) gebildet ist, wobei die Weichmetallplatte (10) auf der dünnen Hartmetallplatte (15) und die Hartmetallplatte (11) auf der Weichmetallplatte (10) gebildet sind.

**3.** Halbleiteranordnung vom Druckkontakt-Typ nach Anspruch 1, dadurch gekennzeichnet, daß die Weichmetallplatte (10) im wesentlichen die gleiche Härte wie die Ausgangselektroden (6-1 bis 6-4) hat.

**4.** Halbleiteranordnung vom Druckkontakt-Typ nach Anspruch 1, dadurch gekennzeichnet, daß die Ausgangselektroden (6-1 bis 6-4) des Halbleiterelementes (2) aus Aluminium gebildet sind und daß die Weichmetallplatte (10) aus einem Metall gebildet ist, das aus der aus Aluminium, Silber und Kupfer bestehenden Gruppe gewählt ist.

**5.** Halbleiteranordnung vom Druckkontakt-Typ nach Anspruch 1, dadurch gekennzeichnet, daß das Halbleiterelement (2) weitere Ausgangselektroden (7-1, 7-2) aufweist, die in einer Lage niedriger als die Ausgangselektroden (6-1 bis 6-4) angeordnet sind, um nicht mittels der einen externen Elektrode (8) in Druckkontakt zu sein, und daß die Ausgangselektroden (6-1 bis 6-4) dicker ausgeführt sind als die weiteren Ausgangselektroden (7-1 bis 7-5).

**6.** Halbleiteranordnung vom Druckkontakt-Typ nach Anspruch 1, dadurch gekennzeichnet, daß ein Isolationsmaterial (16), das dünner ist als die Ausgangselektroden (6-1 bis 6-4), auf einen Halbleiterbereich (5-2), geschichtet ist, der durch Entfernen eines Teiles der Ausgangselektroden (6-1 bis 6-4) freiliegt.

**7.** Halbleiteranordnung vom Druckkontakt-Typ nach Anspruch 6, dadurch gekennzeichnet, daß das Isolationsmaterial (16) wärmeschrumpfbar ist.

**8.** Halbleiteranordnung vom Druckkontakt-Typ nach Anspruch 7, dadurch gekennzeichnet, daß das wärmeschrumpfbare Isolationsmaterial (16) ein Polyimid ist.

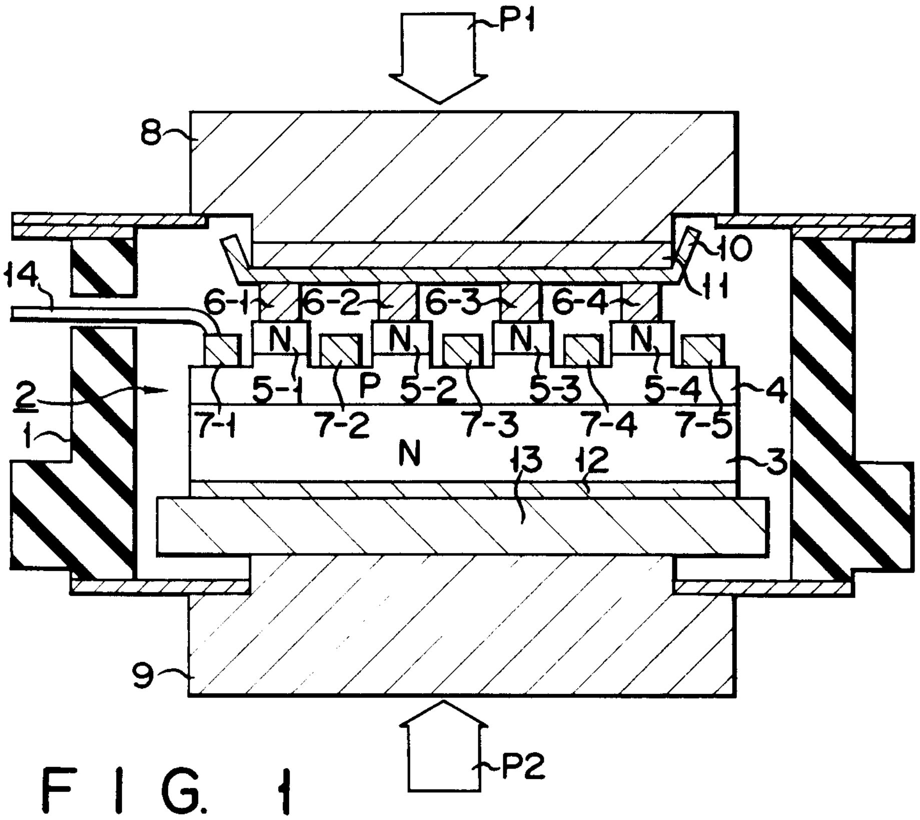
P1
8
10
11
14
6-1
6-2
6-3
6-4
N
N
N
N
5-1
P
5-2
5-3
5-4
4
2
1
7-1
7-2
7-3
7-4
7-5
N
13
12
3
9
P2

F I G. 1

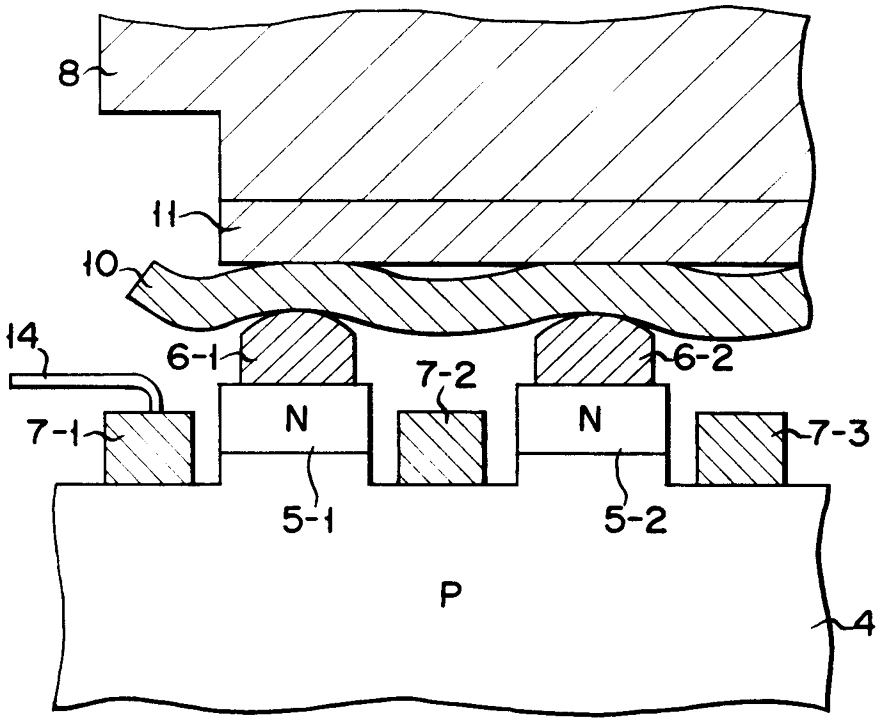
8
11
10
14
6-1
6-2
7-2
N
N
7-1
7-3
5-1
5-2
P
4

F I G. 2

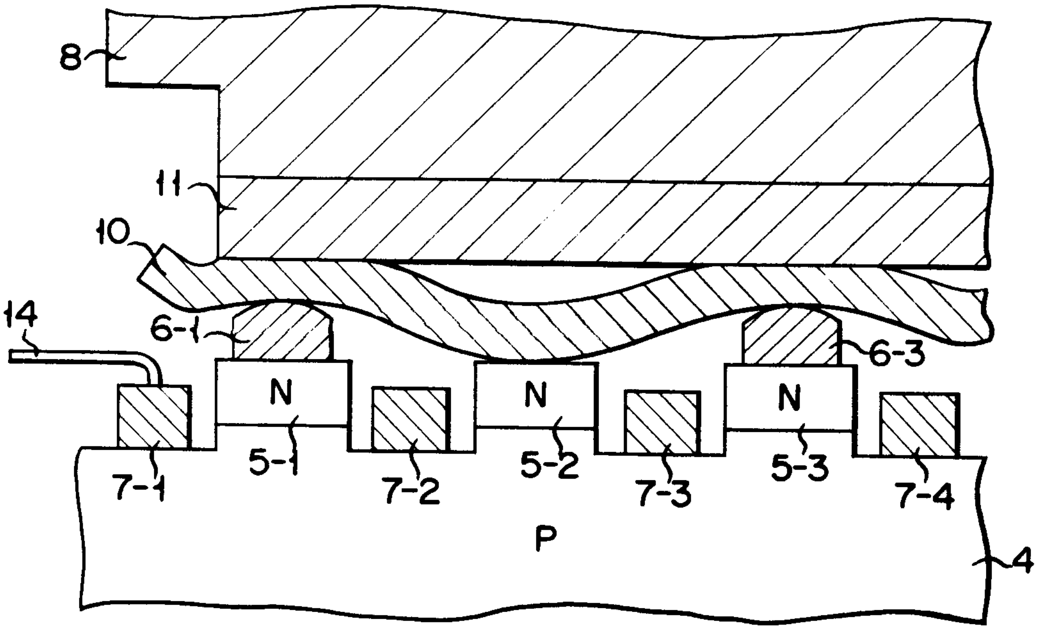
8
11
10
14
6-1
6-3
N
N
N
5-1
5-2
5-3
7-1
7-2
7-3
7-4
P
4

F I G. 3

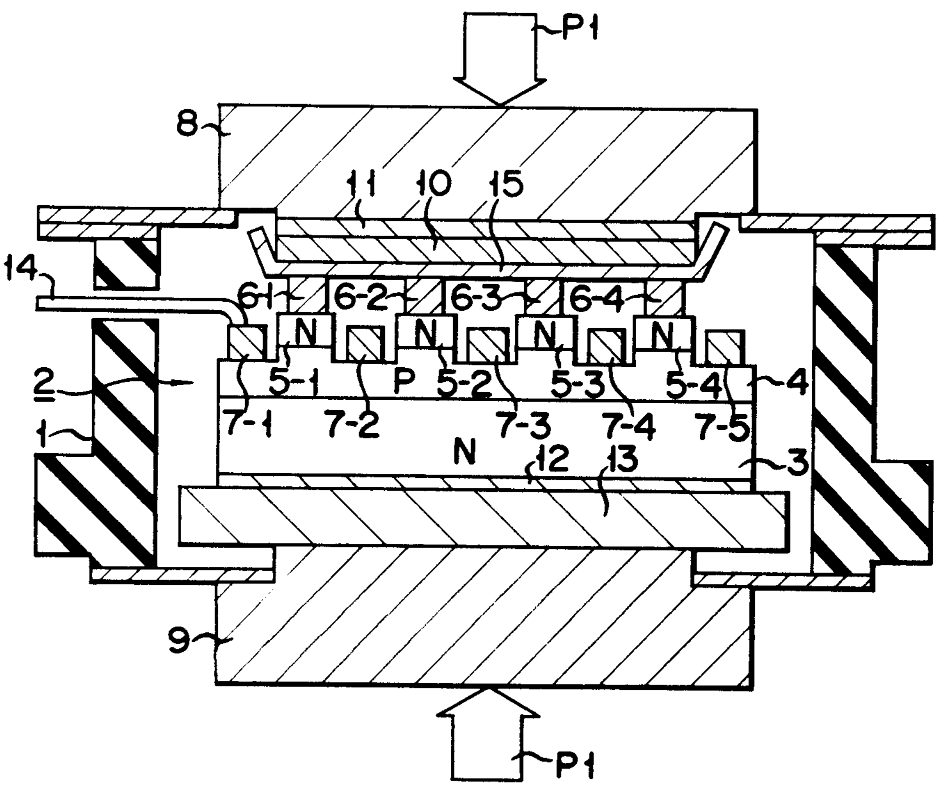
P1
8
11
10
15
14
6-1
6-2
6-3
6-4
N
N
N
N
2
5-1
P
5-2
5-3
5-4
4
1
7-1
7-2
7-3
7-4
7-5
N
12
13
3
9
P1

F I G. 4

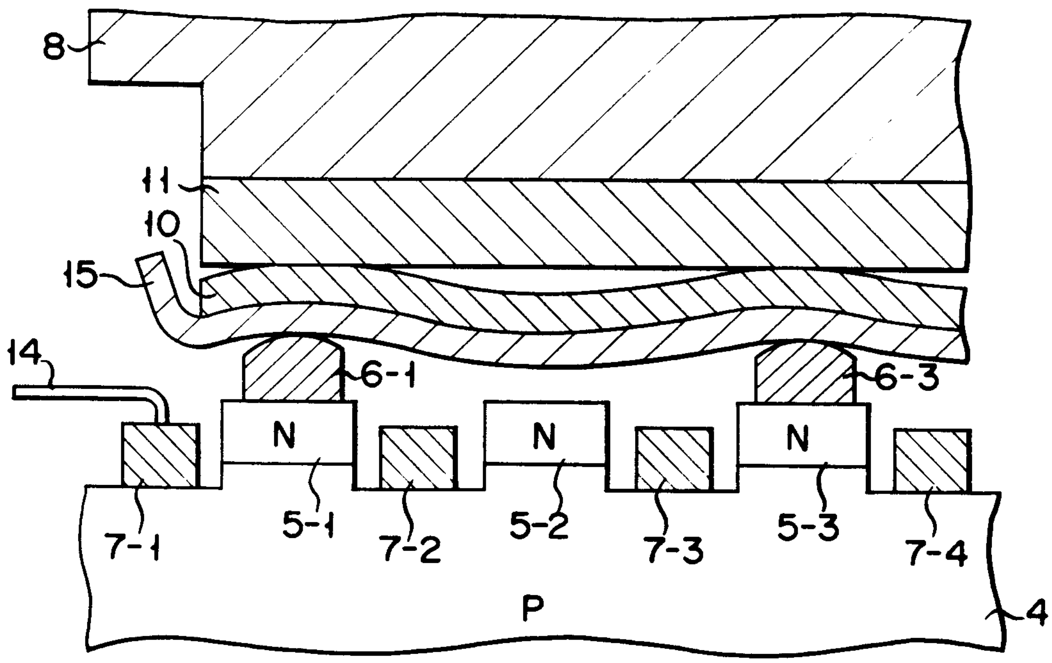
8
11
10
15
14
6-1
6-3
N
N
N
7-1
5-1
7-2
5-2
7-3
5-3
7-4
P
4

FIG. 5

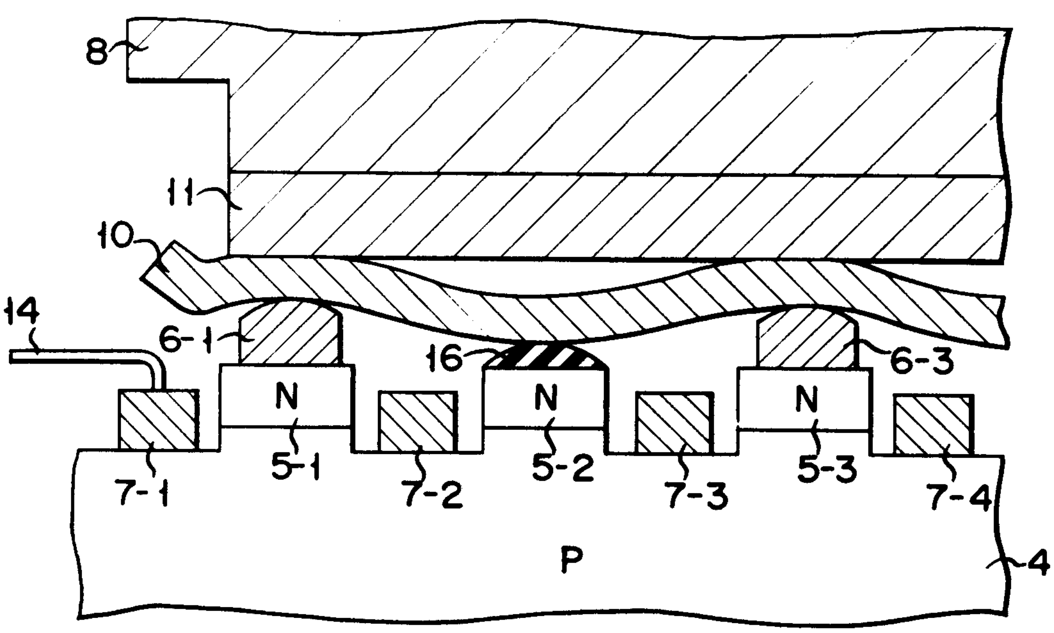
8
11
10
14
6-1
16
6-3
N
N
N
7-1
5-1
7-2
5-2
7-3
5-3
7-4
P
4

FIG. 6

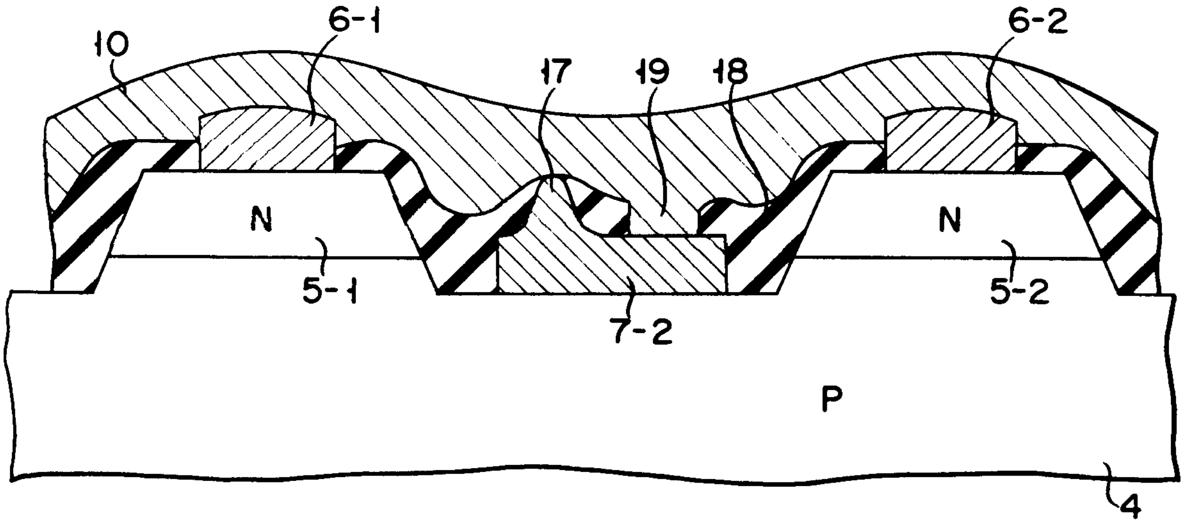


F I G. 7

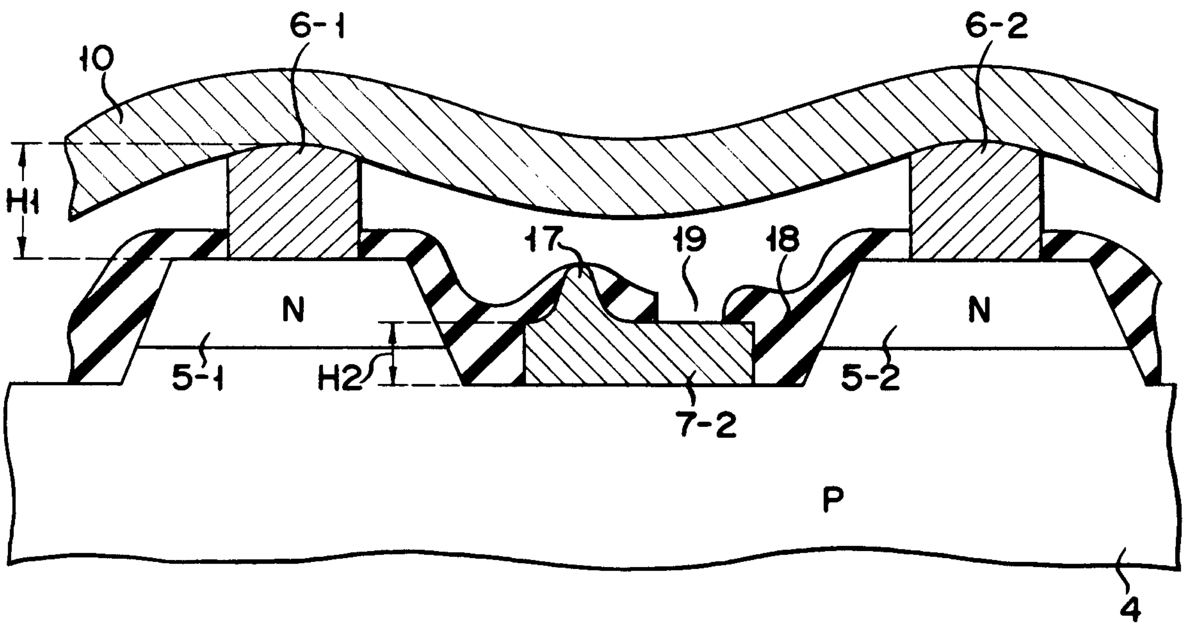


F I G. 8